# EUROPÄISCHE PATENTSCHRIFT

(11) **EP 3 374 117 B1**
(45) Veröffentlichungstag und Bekanntmachung des Hinweises auf die Patenterteilung: **24.03.2021**
(21) Anmeldenummer: 16804696.9
(22) Anmeldetag: 02.11.2016
(51) Int. Cl.: B23K 1/08, B23K 1/015, H05K 3/28, H05K 3/34

(54) **VERFAHREN ZUM ERHÖHEN DER OBERFLÄCHENENERGIE VON LEITERKARTEN DURCH DAMPFPHASENLÖTEN DER LEITERKARTEN**
METHOD FOR INCREASING THE SURFACE ENERGY OF CIRCUIT BOARDS VIA TREATMENT OF THE CIRCUIT BOARDS BY VAPOUR PHASE SOLDERING
PROCÉDÉ D'AUGMENTATION DE L'ENERGIE DE SURFACE D'UN CIRCUIT IMPRIMÉ PAR SOUDAGE EN PHASE VAPEUR

(30) Priorität: 11.11.2015 DE 102015119490
(43) Veröffentlichungstag der Anmeldung: 19.09.2018
(73) Patentinhaber: Endress+Hauser SE+Co. KG, 79689 Maulburg (DE)
(72) Erfinder: BIRGEL, Dietmar, 79650 Schopfheim (DE); BANNWARTH, Alexander, 79739 Schwörstadt (DE)
(74) Vertreter: Andres, Angelika Maria
(86) Internationale Anmeldenummer: PCT/EP2016/076401
(87) Internationale Veröffentlichungsnummer: WO 2017/080883

(56) Entgegenhaltungen:
- DE-A1- 19 519 188
- DE-A1- 19 716 709
- US-A- 3 866 307

## Beschreibung

Die Erfindung bezieht sich auf ein Verfahren zum Erhöhen einer Oberflächenenergie einer mit Bauteilen bestückten Leiterkarte, wobei die Bauteile mittels Wellenlöten gelötet werden, gemäß dem Oberbegriff des Anspruchs 1 (siehe z.B. DE 38 40 098 C1).

Wellenlöten oder Schwalllöten ist ein Lötverfahren, mit dem elektronische Baugruppen halb- oder vollautomatisch nach dem Bestücken gelötet werden. Die Lötseite der Leiterkarten wird zunächst mit einem Flussmittel benetzt. Danach wird die Leiterkarte mittels Konvektionsheizung, Wendelheizung oder Infrarot-Strahlern vorgeheizt. In der Regel wird eine Löttemperatur von 250 °C eingestellt. Nun wird die Leiterkarte über eine oder zwei Lötwellen gefahren.

Das Wellenlöten führt jedoch dazu, dass die Oberflächenenergie der Leiterkarte verringert wird. Dies ist nachteilig, da die Leiterkarte vor dem Einbau mit einem durchsichtigen Schutzlack beaufschlagt wird. Sollte die Oberflächenenergie zu gering sein, benetzt der Schutzlack nicht die gesamte Oberfläche der Leiterkarte mit Schutzlack, sondern nur Teile davon.

Der Erfindung liegt die Aufgabe zugrunde, ein Verfahren zum Erhöhen der Oberflächenenergie von bestückten Leiterkarten anzugeben, bei denen die Bauteile mittels Wellenlöten gelötet sind.

Ein Verfahren zum Erhöhen einer Oberflächenenergie einer mit Bauteilen bestückten Leiterkarten, wobei die Bauteile mittels Wellenlöten gelötet werden, gemäß der Erfindung ist im Anspruch 1 definiert.

Weitere Ausführungsbeispiele der Erfindung sind in den abhängigen Ansprüche definiert.

Das Behandeln der Leiterkarte in einer Dampfphasenlötanlage führt gemäß der Erfindung dazu, dass die Oberflächenenergie der Leiterkarte erhöht wird, ohne dass das Lot mit dem die Bauteile an die Leiterkarte gelötet sind, schmilzt.

Gemäß einer vorteilhaften Ausführungsform dauert das Behandeln der Leiterkarte in einer Dampfphasenlötanlage zwischen 4 Minuten und 12 Minuten.

Gemäß einer vorteilhaften Ausgestaltung umfasst das Wärmeübertragungsmedium Perfluorpolyether.

Gemäß einer günstigen Weiterbildung weist das Wärmeübertragungsmedium einen Siedepunkt unterhalb von 160 °C auf.

Die Erfindung wird anhand der nachfolgenden Zeichnungen näher erläutert. Es zeigt:

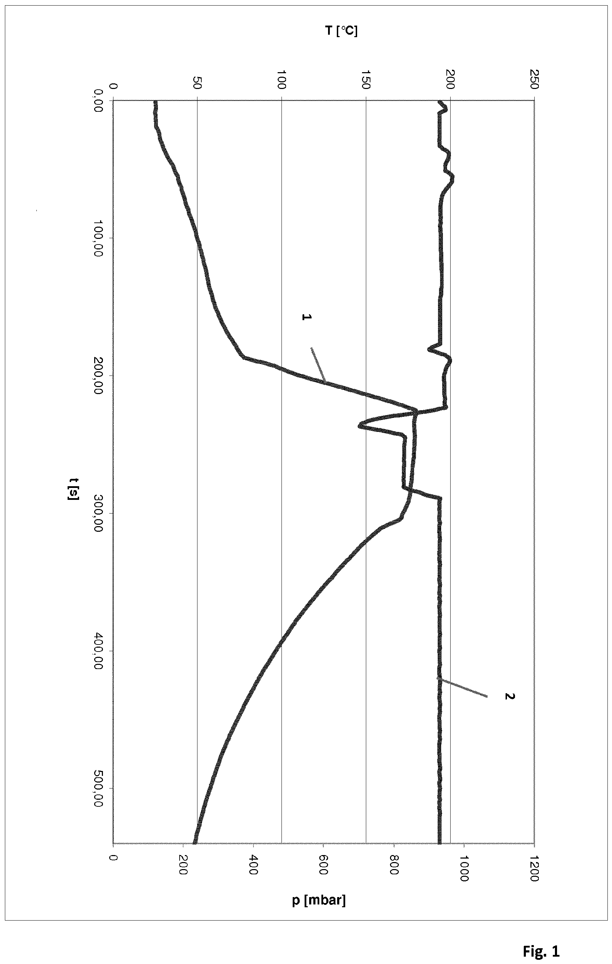

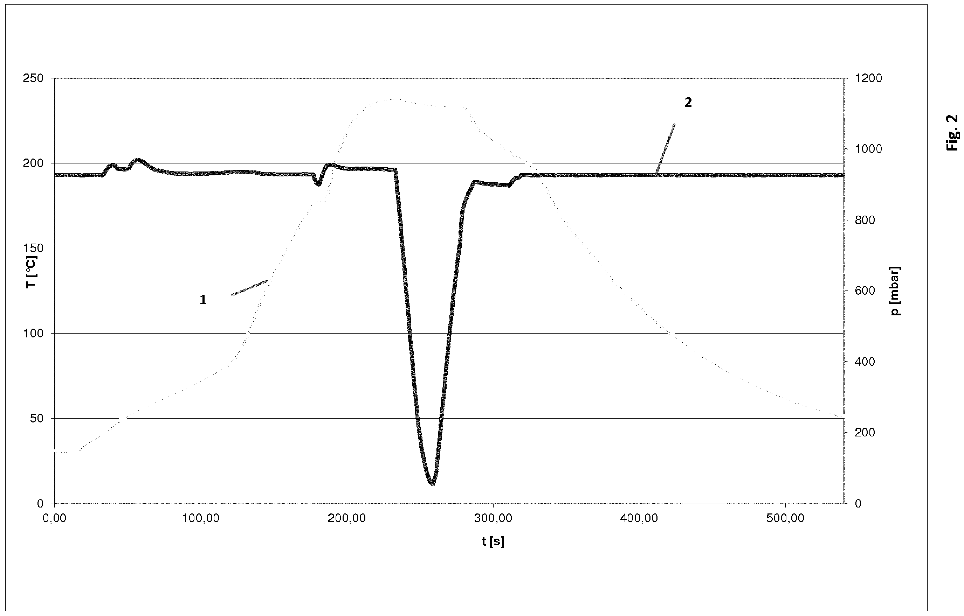

Fig. 1 und Fig. 2: jeweils eine Grafik mit einem zeitlichen Temperaturverlauf und einem zeitlichen Druckverlauf während der Behandlung der Leiterkarte in der Dampfphasenlötanlage.

### Bezugszeichenliste

- 1: Temperaturverlauf
- 2: Druckverlauf

## Patentansprüche

1. Verfahren zum Erhöhen einer Oberflächenenergie einer mit Bauteilen bestückten Leiterkarte, wobei die Bauteile mittels Wellenlöten gelötet werden, umfassend den Schritt Behandeln der Leiterkarte in einer Dampfphasenlötanlage mittels eines Wärmeübertragungsmediums, wobei die Oberflächenenergie der Leiterkarte erhöht wird, ohne dass das Lot, mit dem die Bauteile an die Leiterkarte gelötet werden, schmilzt,
**dadurch gekennzeichnet, dass**
während dem Behandeln der Leiterkarte in der Dampfphasenlötanlage ein zeitlicher Temperaturverlauf (1) und ein zeitlicher Druckverlauf (2) vorliegt, wobei der Temperaturverlauf (1) einen Maximalbereich mit einer maximalen Temperatur zwischen zwei Bereichen mit jeweils steigender und abnehmender Temperatur aufweist, und der Druckverlauf (2) außerhalb des Maximalbereichs einen Druck in der Nähe des Normaldrucks aufweist, und wobei ein Unterdruck erzeugt ist, sobald eine aktuell vorliegende Temperatur in dem Maximalbereich liegt.

2. Verfahren nach Anspruch 1, wobei bei dem Behandeln der Leiterkarte in der Dampfphasenlötanlage die maximale Temperatur zwischen 150 °C und 200 °C liegt.

3. Verfahren nach mindestens einem der vorhergehenden Ansprüche, wobei das Behandeln der Leiterkarte in einer Dampfphasenlötanlage zwischen 4 Minuten und 12 Minuten dauert.

4. Verfahren nach mindestens einem der vorhergehenden Ansprüche, wobei das Wärmeübertragungsmedium Perfluorpolyether umfasst.

5. Verfahren nach mindestens einem der vorhergehenden Ansprüche, wobei das Wärmeübertragungsmedium einen Siedepunkt unterhalb von 160 °C aufweist.

## Claims

1. Method to increase a surface energy of a printed circuit board fitted with components, wherein the components are soldered by means of wave soldering, said method comprising the following step:
Treatment of the printed circuit board in a vapor phase soldering system using a heat transfer medium, wherein the surface energy of the printed circuit board is increased without the solder, which is used to solder the components to the printed circuit board, melting,
**characterized in that,**
during the treatment of the printed circuit board in the vapor phase soldering system, a temperature curve as a function of time, and a pressure curve as a function of time, occur, wherein the temperature curve (1) has a maximum range with a maximum temperature between two ranges with an increasing and decreasing temperature, and the pressure curve outside the maximum range has a pressure close to the normal pressure, and wherein a negative pressure is generated as soon as a temperature that is currently present is located in the maximum range.

2. Method as claimed in Claim 1, wherein, during the treatment of the printed circuit board in the vapor phase soldering system, the maximum temperature is between 150 °C and 200 °C.

3. Method as claimed in at least one of the previous claims, wherein the treatment of the printed circuit board in a vapor phase soldering system takes between 4 and 12 minutes.

4. Method as claimed in at least one of the previous claims, wherein the heat transfer medium comprises perfluoropolyether.

5. Method as claimed in at least one of the previous claims, wherein the heat transfer medium has a boiling point below 160 °C.

## Revendications

1. Procédé destiné à l'augmentation d'une densité surfacique d'énergie d'une carte de circuit imprimé équipée de composants, les composants étant soudés au moyen d'une soudure à la vague, lequel procédé comprend l'étape suivante :
Traitement de la carte de circuit imprimé dans une installation de soudage en phase vapeur au moyen d'un fluide de transfert de chaleur, la densité surfacique d'énergie de la carte de circuit imprimé étant augmentée sans que la soudure, avec laquelle les composants sont soudés sur la carte de circuit imprimé, ne fonde,
**caractérisé en ce que**,
pendant le traitement de la carte de circuit imprimé dans l'installation de soudage en phase vapeur, une courbe de température en fonction du temps et une courbe de pression en fonction du temps sont présentes, la courbe de température (1) présentant une plage maximale avec une température maximale comprise entre deux plages de température respectivement croissante et décroissante et la courbe de pression présentant en dehors de la plage maximale une pression proche de la pression normale, et une dépression étant générée dès qu'une température actuellement présente se situe dans la plage maximale.

2. Procédé selon la revendication 1, pour lequel, lors du traitement de la carte de circuit imprimé dans l'installation de soudage en phase vapeur, la température maximale est comprise entre 150 °C et 200 °C.

3. Procédé selon au moins l'une des revendications précédentes, pour lequel le traitement de la carte de circuit imprimé dans une installation de soudage en phase vapeur prend entre 4 et 12 minutes.

4. Procédé selon au moins l'une des revendications précédentes, pour lequel le fluide de transfert de chaleur comprend un perfluoropolyéther.

5. Procédé selon au moins l'une des revendications précédentes, pour lequel le fluide de transfert de chaleur présente un point d'ébullition inférieur à 160 °C.
